# EUROPÄISCHE PATENTSCHRIFT

(11) **EP 4 136 467 B1**
(45) Veröffentlichungstag und Bekanntmachung des Hinweises auf die Patenterteilung: **11.03.2026**
(21) Anmeldenummer: 21719869.6
(22) Anmeldetag: 12.04.2021
(51) Int. Cl.: G01R 25/00, G01R 31/3835, G01R 31/389, G01R 31/396, G01R 25/04

(54) **VERFAHREN ZUR BESTIMMUNG EINES ZUSTANDS MINDESTENS EINER ZELLE EINER BATTERIE UND EIN DATENVERARBEITUNGSSYSTEM**
METHOD FOR DETERMINING A STATE OF AT LEAST ONE CELL OF A BATTERY, AND DATA-PROCESSING SYSTEM
PROCÉDÉ DE DÉTERMINATION D'UN ÉTAT D'AU MOINS UNE CELLULE D'UNE BATTERIE ET SYSTÈME DE TRAITEMENT DE DONNÉES

(30) Priorität: 17.04.2020 DE 102020110466
(43) Veröffentlichungstag der Anmeldung: 22.02.2023
(73) Patentinhaber: VOLKSWAGEN AKTIENGESELLSCHAFT, 38440 Wolfsburg (DE)
(72) Erfinder: WICK, Christian, 38162 Cremlingen (DE); SCHMIDT, Stephan, 10557 Berlin (DE); BEAURY, Sascha, 38518 Gifhorn (DE)
(74) Vertreter: karo IP
(86) Internationale Anmeldenummer: PCT/EP2021/059447
(87) Internationale Veröffentlichungsnummer: WO 2021/209389

(56) Entgegenhaltungen:
- WO-A1-2020/064932
- KR-B1- 102 016 339

## Beschreibung

Die Erfindung betrifft ein Verfahren zur Bestimmung eines Zustands einer Zelle einer Batterie, insbesondere einer Hochvoltbatterie. Insbesondere ist das Verfahren auf die Bestimmung eines Zustands einer Zelle unter Berücksichtigung der Zustände anderer Zellen derselben Batterie gerichtet.

Derartige Hochvoltbatterien werden insbesondere in Kraftfahrzeugen zur Speicherung von elektrischer Energie für den Antrieb von Traktionsantrieben eingesetzt. Dabei setzt sich eine Batterie regelmäßig aus einer Mehrzahl von Zellen zusammen, wobei jede Zelle eine Klemmenspannung von 1,5 bis 4 Volt aufweist. Die Zellen werden zumindest teilweise in Reihe geschaltet, so dass eine Traktionsspannung von 60 bis 1.500 Volt Gleichspannung bereitgestellt wird.

Aufgrund aktueller und kommender Gesetzgebungen ist es erforderlich, den Zustand der Batterie bzw. der Zellen im Betrieb eines Kraftfahrzeuges zu erfassen. Insbesondere kann durch die Bestimmung des Zustands der Zellen eine Ausfall-Früherkennung und eine Service-Früherkennung erfolgen, so dass ein Ausfall einer Zelle bzw. der Batterie im Betrieb vermieden wird und ein rechtzeitiger Austausch der Zelle bzw. der Batterie vorgenommen werden kann.

Eine Beschädigung einer Hochvoltbatterie, z. B. von unten, kann nicht elektronisch erkannt werden. Dadurch kann ein Nutzer eines Kraftfahrzeuges vor einer möglichen Schädigung der Zellen nicht gewarnt werden.

Die sogenannte thermische Propagation wird erst sehr spät erkannt. Eine Früherkennung bzw. direkte Temperaturmessung einer defekten Zelle, bei der die innere Temperatur ansteigt, bevor die Zelle am Ende zu brennen beginnt, gibt es derzeit nicht. Es ist möglich, dass es zukünftig Gesetzgebung geben wird, die eine frühe Warnung des Nutzers vor einer Gefährdung fordert.

Die Zellinnentemperatur kann heute in Kraftfahrzeugen nicht gemessen werden. Stattdessen wird indirekt die Zellmodultemperatur, also die Temperatur einer Mehrzahl von Zellen, gemessen. Diese indirekte Messung der Temperatur einer Zelle durch die Messung der Zellmodultemperatur ist nachteilig, da Änderungen der Innentemperatur einer Zelle nur sehr zeitverzögert sensiert werden.

Ein Verfahren zur Bestimmung der Zellinnentemperatur ist die sogenannte Impedanzspektroskopie. Bei der Impedanzspektroskopie wird eine Phasenbeziehung von Strom und Spannung ausgewertet und damit der Real- bzw. Imaginärteil eines Zellwiderstandes ermittelt. Dieses geschieht, indem der Frequenzgang eines eingeprägten Stromes von ganz kleinen Frequenzen (0,1Hz) bis zu großen Frequenzen (10kHz) durchfahren wird. Dieses Verfahren erfordert viel Zeit und es wird zur Einprägung des Stroms viel Energie aus der Zelle entnommen. Außerdem wirken sich Störungen, die durch die Verbraucher des Kraftfahrzeugs erzeugt werden, stark aus und verfälschen das Messsignal. Die Messergebnisse von Spannung und Strom werden durch komplexe Algorithmik ausgewertet. Dabei lässt sich dann ein Rückschluss z. B. auf den Absolutwert der Zellinnentemperatur schließen. Dieses Verfahren ist sehr störempfindlich und wird heute nur unter Laborbedingungen eingesetzt.

Aus der DE 197 55 417 A1 ist eine Auswerteschaltung zur Ermittlung komplexer Impedanzen bekannt. Diese wird zur Analyse der Eigenschaften von Flüssigkeiten eingesetzt.

Aus der DE 10 2014 222 950 A1 ist eine Lithium-Luft Batterie bekannt.

Aus der DE 10 2014 202 927 A1 ist ein Verfahren zum Betreiben einer Batterieeinrichtung bekannt. Dabei wird ein Leistungszustand der einzelnen Zellen ermittelt. Die schwächsten Zellen werden ermittelt und deaktiviert, so dass deren Alterung infolge Benutzung verlangsamt wird.

Die KR 102 016 339 B1 ist auf ein Diagnosegerät und ein Verfahren zur Bestimmung eines state of health einer Mehrzahl von Batteriezellen gerichtet.

Die WO 2020/0064932 A1 ist auf ein Verfahren und eine Vorrichtung zur Diagnose von Batteriezellen gerichtet.

Aufgabe der vorliegenden Erfindung ist es, die mit Bezug auf den Stand der Technik angeführten Probleme zumindest teilweise zu lösen. Insbesondere soll ein Verfahren zur Bestimmung eines Zustands einer Zelle einer Batterie vorgeschlagen werden. Insbesondere soll damit eine beschädigte Zelle im Betrieb eines Kraftfahrzeuges frühzeitig erkannt und eine Gefährdung eines Nutzers des Kraftfahrzeuges verringert oder verhindert werden.

Zur Lösung dieser Aufgaben trägt ein Verfahren mit den Merkmalen gemäß Patentanspruch 1 bei. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und/oder Details aus den Figuren ergänzt werden, wobei weitere Ausführungsvarianten der Erfindung aufgezeigt werden.

Es wird ein Verfahren zur Bestimmung eines Zustands mindestens einer Zelle einer Batterie vorgeschlagen, wobei die Batterie eine Mehrzahl von Zellen aufweist, die miteinander in Reihe geschaltet sind. Das Verfahren umfasst zumindest die folgenden Schritte:
a) Beaufschlagen der Mehrzahl von Zellen mit einem Wechselstrom;
b) Messen der dadurch erzeugten Wechselspannung an zumindest einer ersten Zelle und einer zweiten Zelle;
c) Analyse einer Phasenlage der gemessenen Wechselspannung jeder Zelle; wobei ein Unterschied zumindest zwischen einer ersten Phasenlage einer an der ersten Zelle gemessenen ersten Wechselspannung und einer zweiten Phasenlage einer an der zweiten Zelle gemessenen zweiten Wechselspannung einen Rückschluss auf einen Unterschied der Zustände zumindest der ersten Zelle und der zweiten Zelle erzeugt, wobei nur die Phasenlage der an den Zellen gemessenen Wechselspannungen zueinander und nicht die Phasenbeziehung zwischen einem Strom und einer Spannung ausgewertet wird.

Die obige (nicht abschließende) Einteilung der Verfahrensschritte in a) bis c) soll vorrangig nur zur Unterscheidung dienen und keine Reihenfolge und/oder Abhängigkeit erzwingen. Auch die Häufigkeit der einzelnen Verfahrensschritte kann variieren. Ebenso ist möglich, dass Verfahrensschritte einander zumindest teilweise zeitlich überlagern. Ganz besonders bevorzugt finden die Verfahrensschritte b) und c) während Schritt a) statt. Schritt c) kann bedingt sein und ggf. nur dann ausgeführt werden, wenn Schritt b) ergibt, dass die gemessenen Wechselspannungen keine Phasenverschiebung aufweisen. Insbesondere werden die Schritte a) bis c) in der angeführten Reihenfolge durchgeführt.

Insbesondere wird bei dem hier beschriebenen, auch als "differentiell messende Impedanzspektroskopie" zu bezeichnenden Verfahren nur der Unterschied der Imaginärteile der Zellwiderstände zueinander ermittelt. Es wird nicht die Phasenbeziehung zwischen einem Strom und einer Spannung ausgewertet, sondern nur die Phasenlage bzw. Phasenbeziehung der an den Zellen gemessenen Wechselspannungen zueinander. Mögliche Störungen des Stromsignals wirken sich gleichzeitig und mit gleicher Größe auf alle Zellen der Batterie bzw. der in Reihe geschalteten Zellen aus und werden hier als Gleichtaktanteil nicht gemessen. Mit dem vorliegenden Verfahren werden ausschließlich Änderungen der Imaginärteile der Zellwiderstände zueinander gemessen und ausgewertet.

Gemäß Schritt a) wird insbesondere ein Wechselstrom, z. B. mit einer Frequenz von mehr als 1 Hz [Hertz], insbesondere zwischen 1 Hz und 10 kHz, bevorzugt zwischen 10 Hz und 10 kHz, besonders bevorzugt von 100 Hz, in die Zellen der Batterie eingeprägt.

Gemäß Schritt b) wird die so erzeugte Wechselspannung an den einzelnen Zellen der Batterie, insbesondere an einer Auswahl oder an allen Zellen der Batterie, gemessen.

Gemäß Schritt c) wird die Phasenbeziehung der gemessenen Wechselspannungen zueinander, z. B. elektronisch, ausgewertet. Insbesondere wird die jeweilige Phasenlage jeder gemessenen Wechselspannung erfasst und mit den Phasenlagen der anderen Wechselspannungen verglichen. Der Unterschied der Phasenlagen kann mittels (abrufbaren und/oder vorgegebenen) Grenzwerten, Schwellwerten, Akzeptanzbereichen, Erfahrungswerten, Kennfeldern oder dergleichen klassifiziert werden, so dass ein Rückschluss auf den Zustand wenigstens einer der geprüften Zellen erreicht wird. Der Rückschluss kann einen Wahrscheinlichkeitswert umfassen für die Erforderlichkeit eines potenziellen bzw. bevorstehenden Ausfalls mindestens einer Zelle, eine (existente oder zu erwartende) Beschädigung der Zelle, eine (ergänzende) Servicenotwendigkeit bezüglich mindestens einer Zelle, etc. umfassen. Die Analyse bzw. Auswertung kann rein rechnerisch mit Einsatz von Datenverarbeitungsmitteln erfolgen. Diese können dann auch eine Information über den Rückschluss ausgeben.

Insbesondere werden im Rahmen des Verfahrens ausschließlich die an den Zellen anliegenden Wechselspannungen der Zellen gemessen.

Insbesondere kann die Frequenz einen beliebigen Wert zwischen 1Hz und 10kHz aufweisen. Insbesondere kann der Wechselstrom eine konstante oder eine sich ändernde Frequenz aufweisen. Insbesondere kann der Wechselstrom auch nur eine Periodenlänge aufweisen.

Insbesondere werden die an den Zellen gemessenen Wechselspannungen jeweils durch einen Bandpass gefiltert und das so jeweils erzeugte Signal durch einen Verstärker mit Komparator verändert. Die jeweils durch den Verstärker mit Komparator veränderten Signale werden in einem Phasendetektor zusammengeführt. Eine Phasenverschiebung der gemessenen Wechselspannungen ist durch ein erstes Ausgangssignal darstellbar.

Mit dem Bandpass kann die dem aufgeprägten Wechselstrom zuzuordnende und an der Zelle dadurch hervorgerufene Wechselspannung erfasst werden. Der Bandpass ermöglicht also insbesondere die Erfassung einer Wechselspannung, die die Frequenz des Wechselstroms aufweist. Insbesondere werden so Gleichspannungsanteile und Wechselspannungen anderer Frequenzen nicht erfasst bzw. ausgeblendet.

Der Verstärker mit Komparator liefert insbesondere ein verändertes Signal, dass die gemessene und durch den Bandpass gefilterte Wechselspannung durch ein Rechtecksignal darstellt. Liegt eine Phasenverschiebung gegenüber anderen Wechselspannungen vor, wird dies durch eine Verschiebung der Rechtecksignale entlang der Zeitachse deutlich.

Insbesondere werden die durch den Verstärker mit Komparator veränderten Signale als zweites Ausgangssignal dargestellt, so dass darstellbar ist, welche Wechselspannung bzw. Wechselspannungen eine Phasenverschiebung gegenüber anderen Wechselspannungen aufweisen.

Sobald sich die Imaginärteile der Zellwiderstände unterscheiden und damit eine Phasenverschiebung der an einer Zelle gemessenen Wechselspannung erzeugen, wird durch das erste Ausgangssignal insbesondere ein Rechtecksignal erzeugt. Dieses lässt einen Rückschluss auf einen Unterschied der Zellen zu, z. B. auf einen Temperaturanstieg bei Beginn einer thermischen Propagation. Die zeitliche Länge des Rechtecksignals ist insbesondere proportional bzw. gleich der Stärke des Unterschieds, also z. B. der Temperaturdifferenz.

Wird das Rechtecksignal des ersten Ausgangssignals zu Beginn einer Fahrt eines Kraftfahrzeuges, an dem insbesondere alle Zelltemperaturen gleich sind, gemessen bzw. ermittelt, so kann davon ausgegangen werden, dass mindestens eine Zelle defekt ist. Eine Ursache kann ein zeitlich vorgelagertes Schädigungsereignis, z. B. das Eindrücken der Batterie durch einen Poller von einer Unterseite eines Kraftfahrzeuges her, oder eine stark gealterte Zelle sein.

Wenn der Absolutwert einer Zelltemperatur in der Nähe einer Zelle z. B. mit einem Temperaturfühler gemessen wird, dann kann die Phasenlage jeder einzelnen Wechselspannung, die an dem zweiten Ausgangssignal identifizierbar ist, einen Rückschluss auf die jeweilige Zellinnentemperatur ermöglichen. Mit dieser Zusatzinformation kann nachgelagert der SOC (state-of-charge der Zelle und ggf. zusätzlich der Batterie, also der Ladezustand der Zelle und ggf. zusätzlich der Batterie) oder SOH (state-of-health, also der Alterungszustand der Zelle) genauer bestimmt werden.

Die Ausgangssignale können durch eine Auswerteeinheit ausgewertet werden.

Insbesondere können Wechselspannungen aller Zellen zueinander gemessen werden, oder für einen Zellstapel von mehreren (z. B. 6 oder 12,..) Zellen wird jeweils eine Schaltungseinheit zur Ermittlung der Wechselspannung des Zellstapels eingesetzt. Dieses ist insbesondere für einen Aufbau einer Hochvolt-Batterie mit Zellmodulen oder Zellstacks von Vorteil, da die Zellstapel eine max. Spannung von 60 Volt in der Regel nicht überschreiten.

Mit dem vorgeschlagenen Verfahren können insbesondere Temperaturdifferenzen zwischen den Zellen, mechanische Beschädigungen oder signifikante Alterungserscheinungen einzelner Zellen ermittelt werden.

Die zur Durchführung des Verfahrens erforderlichen Schaltungen können in eine Steuerung der Batterie integriert oder separat ausgeführt werden, z. B. als application-specific integrated circuit - ASIC, also als eine anwendungsspezifische Schaltung.

Insbesondere werden die an den Zellen gemessenen Wechselspannungen jeweils durch einen Bandpass gefiltert und das so jeweils erzeugte Signal durch einen Verstärker verändert. Die jeweils veränderten Signale werden (jeweils) einem Lock-in-Verstärker, der mit einem Referenzspannungssignal beaufschlagt wird, zugeführt, wobei der (jeweilige) Lock-in-Verstärker für jede gemessene Wechselspannung eine Gleichspannung ausgibt, deren jeweilige Höhe proportional zumindest zu einer Phasenverschiebung zwischen der gemessenen Wechselspannung und dem Referenzspannungssignal ist.

Der Verstärker liefert insbesondere ein verändertes Signal, dass die gemessene und durch den Bandpass gefilterte Wechselspannung durch ein Rechtecksignal darstellt.

Das Referenzspannungssignal ist insbesondere ebenfalls ein Rechtecksignal.

Das Referenzspannungssignal weist insbesondere dieselbe Frequenz wie der aufgeprägte Wechselstrom auf.

Ein Lock-in-Verstärker ist insbesondere ein Verstärker zur Messung eines schwachen elektrischen Wechselsignals, das mit einem in Frequenz und Phase bekannten Referenzsignal moduliert ist. Das Gerät stellt einen schmalbandigen Bandpassfilter dar und verbessert dadurch das Signal-Rausch-Verhältnis (SNR, Signal to Noise Ratio).

Die beiden Eingangssignale des (jeweiligen) Lock-in-Verstärkers, also einerseits die gemessene Wechselspannung, die im Bandpass gefiltert und durch einen Verstärker zu einem veränderten Signal umgewandelt wurde, und andererseits das Referenzspannungssignal, werden in einem Mischer bzw. Multiplikator miteinander multipliziert und anschließend in einem Tiefpass integriert. Der Tiefpass ermöglicht die Ausblendung von Signalen höherer Frequenz, die beim Multiplizieren der Eingangssignale erzeugt werden.

Der Lock-in-Verstärker berechnet insbesondere die Kreuzkorrelation zwischen dem veränderten Signal und dem Referenzspannungssignal für eine feste Phasenverschiebung zwischen dem veränderten Signal einer Zelle und dem Referenzspannungssignal. Die Kreuzkorrelation für Signale unterschiedlicher Frequenz ist Null. Ist daher die Frequenz des veränderten Signals von der des Referenzspannungssignals verschieden, liefert der Lock-in-Verstärker kein Ausgangssignal. Nur für gleiche Frequenzen liefert die Kreuzkorrelation einen Wert ungleich Null und damit einen Beitrag im Ausgangssignal des Lock-in-Verstärkers. Durch Wahl der passenden Frequenz des Referenzspannungssignals lässt sich also die Phasenverschiebung zwischen dem veränderten Signal jeder Zelle und dem für alle Zellen verwendeten Referenzspannungssignal ermitteln.

Der Lock-in-Verstärker liefert für jede Zelle ein Gleichspannungssignal, dessen Wert eine Aussage zur Phasenlage der gemessenen Wechselspannung gegenüber dem Referenzspannungssignal liefert.

Ein von anderen Gleichspannungssignalen anderer Zellen abweichendes Gleichspannungssignal einer Zelle bedeutet, dass hier eine Phasenverschiebung vorliegt und die Zelle ggf. schadhaft ist.

Voneinander nicht abweichende Gleichspannungssignale deuten darauf hin, dass keine Phasenverschiebungen vorliegen und dass keine der Zellen defekt ist.

Insbesondere werden die Gleichspannungssignale jeweils einem Analog-Digital-Wandler zugeführt und dort in ein digitales Ausgangssignal umgewandelt. Dieses digitale Ausgangssignal kann einer Auswerteeinheit zugeführt und darin ausgewertet werden.

Insbesondere weist das Referenzspannungssignal die Frequenz des aufgeprägten Wechselstroms auf. Insbesondere ist aber die Phasenlage des Referenzspannungssignals nicht stabil zu der Phasenlage des aufgeprägten Wechselstroms. Damit können sich die Wechselspannungen der Zellen mit der Zeit gegenüber dem Referenzspannungssignal aber nicht zueinander, also relativ zu den anderen Zellen, verändern.

Sobald sich der Imaginärteil des Zellwiderstandes einer Zelle ändert, z. B. Temperaturanstieg bei Beginn einer thermischen Propagation, hat diese Zelle zu jeder Zeit eine andere Wechselspannung bzw. eine andere Phasenlage als die anderen Zellen.

Insbesondere entspricht das Referenzspannungssignal in Frequenz und Phasenlage dem durch den Bandpass gefilterten Signal einer Zelle der Batterie.

Damit kann insbesondere das Referenzspannungssignal eine gemeinsame Phasenlage mit den gemessenen Wechselspannungen der Zellen aufweisen, insbesondere der nicht defekten Zellen.

Das Referenzspannungssignal wird insbesondere aus dem Bandpass-gefilterten Signal der gemessenen Wechselspannung einer Zelle generiert. Dieses Signal wird durch einen Verstärker zu einem veränderten Signal umgewandelt und als Referenzspannungssignal verwendet.

Insbesondere wird das für das Referenzspannungssignal verwendete und durch den Bandpass gefilterte Signal einer Zelle hinsichtlich seiner Phasenlage verschoben, so dass es als phasenverschobenes Signal einer Zelle das Referenzspannungssignal des Lock-in-Verstärkers bildet.

Insbesondere ist ein Phasenschieber vorgesehen, mit dem das Referenzspannungssignal hinsichtlich der Phasenlage verschoben werden kann. Mit dem Phasenschieber lässt sich die Phasenlage des Referenzspannungssignals verändern und so nur der Imaginärteil der Spannung (und damit des Widerstandes) verstärken. Dadurch kann eine Spannungsdifferenz zwischen den Wechselspannungen der Zellen verbessert eingestellt werden.

Insbesondere werden die an den Zellen gemessenen Wechselspannungen jeweils durch einen Bandpass gefiltert und das so jeweils erzeugte Signal durch einen Verstärker verändert, wobei die jeweils veränderten Signale zweier Zellen einem Differenzverstärker zugeführt werden. Jede Zelle ist mit jeder anderen in einer Reihenschaltung verbundenen Zelle über jeweils einen Differenzverstärker verbunden. Der Differenzverstärker erzeugt nur dann ein Messsignal, wenn eine Phasenverschiebung zwischen den veränderten Signalen der zwei Zellen vorliegt.

Insbesondere sind also die in der Reihenschaltung hintereinander angeordneten Zellen jeweils mit der vorgelagerten sowie mit der nachgelagerten Zelle über jeweils einen Differenzverstärker verbunden.

Dieses Messsignal kann einem Analog-Digital-Wandler zugeführt und dort in ein digitales Ausgangssignal umgewandelt werden. Dieses digitale Ausgangssignal kann einer Auswerteeinheit zugeführt und darin ausgewertet werden.

Es wird weiter ein Datenverarbeitungssystem vorgeschlagen, das zur Durchführung des beschriebenen Verfahrens ausgestattet, konfiguriert oder programmiert ist, wobei das Datenverarbeitungssystem Phasenlagen von, an einer Mehrzahl von Zellen einer Batterie gemessenen, Wechselspannungen verarbeitet und miteinander vergleicht.

Weiter kann das Verfahren auch von einem Computer bzw. mit einem Prozessor einer Steuereinheit ausgeführt werden.

Das Verfahren kann insbesondere in einem Steuergerät oder einer Steuereinheit implementiert sein, wobei das Steuergerät zumindest zur Diagnose, ggf. auch zum Betrieb, der Batterie vorgesehen ist.

Die Batterie kann in einem Kraftfahrzeug zur Speicherung von Energie eingesetzt werden, wobei über die Batterie zumindest ein Traktionsantrieb des Kraftfahrzeuges mit elektrischer Energie versorgt wird.

Es wird insbesondere ein Kraftfahrzeug mit einem Traktionsantrieb und der beschriebenen Batterie sowie dem Datenverarbeitungssystem vorgeschlagen.

Es kann ein computerlesbares Speichermedium vorgesehen sein, das Befehle umfasst, die bei der Ausführung durch einen Computer/Prozessor diesen veranlassen, das Verfahren bzw. mindestens einen Teil der Schritte des vorgeschlagenen Verfahrens auszuführen.

Die Ausführungen zu dem Verfahren sind insbesondere auf das Kraftfahrzeug, die Batterie und/oder das computerimplementierte Verfahren (also den Computer bzw. den Prozessor, das Datenverarbeitungssystem, das computerlesbare Speichermedium) übertragbar und umgekehrt.

Für das vorgeschlagene Verfahren bzw. das Datenverarbeitungssystem wird insbesondere keine Synchronisationsleitung zwischen Stromanregung und Spannungsmessung benötigt, da die Phasenlage zum Strom nicht benötigt wird.

Die zur Durchführung des Verfahrens geeigneten Schaltungen bzw.

Datenverarbeitungssysteme sind insbesondere robust gegen Störungen.

Insbesondere ist keine zusätzliche Intelligenz (µC) zur Auswertung der mit dem Verfahren ermittelten Messwerte notwendig.

Die Zeit zur Durchführung des Verfahrens bzw. die Zeit, in der der Wechselstrom aufgeprägt wird, ist sehr kurz, z. B. höchstens eine Sekunde, insbesondere weniger als zwei Sekunden. Damit kann gewährleistet werden, dass der mindestens einen Zelle bzw. der Batterie nur wenig Energie entnommen wird.

Zur Aufprägung des Wechselstroms kann ein schon im Kraftfahrzeug vorhandener Verbraucher, z. B. ein HV-Heizer, ein Pulswechselrichter oder eine Heizmattenansteuerung, genutzt werden. Ebenso kann der sich verändernde Strom des elektrischen Antriebs als Signalquelle dienen.

Die Verwendung unbestimmter Artikel ("ein", "eine", "einer" und "eines"), insbesondere in den Patentansprüchen und der diese wiedergebenden Beschreibung, ist als solche und nicht als Zahlwort zu verstehen. Entsprechend damit eingeführte Begriffe bzw. Komponenten sind somit so zu verstehen, dass diese mindestens einmal vorhanden sind und insbesondere aber auch mehrfach vorhanden sein können.

Vorsorglich sei angemerkt, dass die hier verwendeten Zahlwörter ("erste", "zweite", ...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung. Soweit ein Bauteil mehrfach vorkommen kann ("mindestens ein"), kann die Beschreibung zu einem dieser Bauteile für alle oder ein Teil der Mehrzahl dieser Bauteile gleichermaßen gelten, dies ist aber nicht zwingend.

Die Erfindung sowie das technische Umfeld werden nachfolgend anhand der beiliegenden Figuren näher erläutert. Es ist darauf hinzuweisen, dass die Erfindung durch die angeführten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung zu kombinieren. Insbesondere ist darauf hinzuweisen, dass die Figuren und insbesondere die dargestellten Größenverhältnisse nur schematisch sind. Es zeigen:
- Fig. 1:: ein Diagramm;
- Fig. 2:: eine erste Schaltung;
- Fig. 3:: eine zweite Schaltung;
- Fig. 4:: eine dritte Schaltung; und
- Fig. 5:: eine vierte Schaltung.

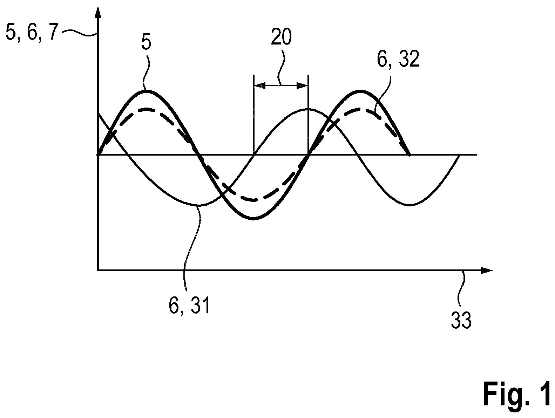

Die Fig. 1 zeigt ein Diagramm. An der vertikalen Achse ist der Wechselstrom 5 und die Wechselspannung 6, 7 aufgetragen. An der horizontalen Achse ist die Zeit 33 aufgetragen. Es sind die Verläufe des Wechselstroms 5 und einer ersten Wechselspannung 6 dargestellt. Die erste Wechselspannung 6 umfasst einen Imaginärteil 31 und einen Realteil 32. Der Imaginärteil 31 weist gegenüber dem Realteil 32 eine Phasenverschiebung 20 auf.

Ein Verfahren zur direkten Messung der Zellinnentemperatur ist die sogenannte Impedanzspektroskopie. Bei der Impedanzspektroskopie wird eine Phasenbeziehung von Strom 5 und Spannung 6, 7 ausgewertet und damit der Realteil 32 bzw. Imaginärteil 31 eines Zellwiderstandes ermittelt. Dieses geschieht, indem der Frequenzgang eines eingeprägten Stromes 5 von ganz kleinen Frequenzen (0,1Hz) bis zu großen Frequenzen (10kHz) durchfahren wird. Dieses Verfahren erfordert viel Zeit und es wird zur Einprägung des Stroms 5 viel Energie aus der Zelle 1, 2, 3 entnommen. Außerdem wirken sich Störungen, die durch die Verbraucher des Kraftfahrzeugs erzeugt werden, stark aus und verfälschen das Messsignal. Die Messergebnisse von Spannung 6 und Strom 5 werden durch komplexe Algorithmik ausgewertet. Dabei lässt sich dann ein Rückschluss z. B. auf den Absolutwert der Zellinnentemperatur schließen. Dieses Verfahren ist sehr störempfindlich und wird heute nur unter Laborbedingungen eingesetzt.

Bei dem hier beschriebenen, auch als "differentiell messende Impedanzspektroskopie" zu bezeichnenden Verfahren wird nur der Unterschied der Imaginärteile 31 der Zellwiderstände zueinander ermittelt. Insbesondere wird hier nicht die Phasenbeziehung zwischen einem Strom 5 und einer Spannung 6 ausgewertet, sondern nur die Phasenlage 8, 9 bzw. Phasenbeziehung der an den Zellen 1, 2, 3 gemessenen Wechselspannungen 6, 7 zueinander. Mögliche Störungen des Stromsignals wirken sich gleichzeitig und mit gleicher Größe auf alle Zellen 1, 2, 3 der Batterie 4 bzw. der in Reihe geschalteten Zellen 1, 2, 3 aus und werden hier als Gleichtaktanteil nicht gemessen. Mit dem vorliegenden Verfahren werden ausschließlich Änderungen der Imaginärteile 31 der Zellwiderstände zueinander gemessen und ausgewertet.

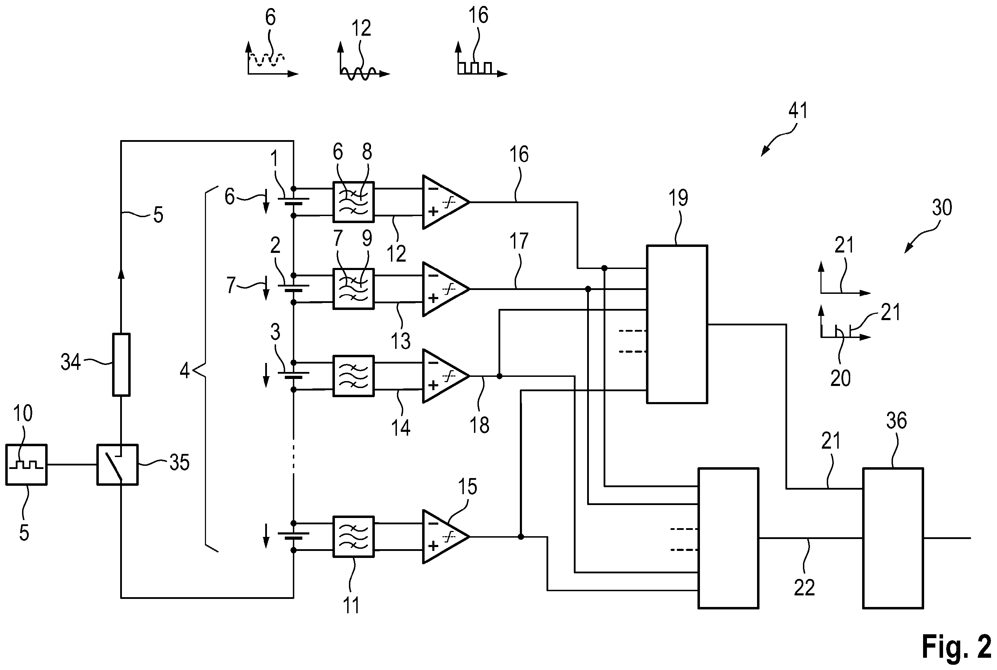

Die in den Fig. 2 bis 5 dargestellten Schaltungen 41, 42, 43, 44 stellen Datenverarbeitungssysteme dar, die zur Durchführung des Verfahrens geeignet ausgeführt sind. Auf die Ausführungen zu Fig. 1 wird jeweils verwiesen.

Fig. 2 zeigt eine erste Schaltung 41. Die erste Schaltung 41 ermöglicht die Durchführung des Verfahrens zur Bestimmung eines Zustands mindestens einer Zelle 1, 2, 3 einer Batterie 4, wobei die Batterie 4 eine Mehrzahl von Zellen 1, 2, 3, ... bis n aufweist, die miteinander in Reihe geschaltet sind. Gemäß Schritt a) erfolgt ein Beaufschlagen der Mehrzahl von Zellen 1, 2, 3 mit einem Wechselstrom 5. Gemäß Schritt b) erfolgt ein Messen der dadurch erzeugten Wechselspannung 6, 7 an zumindest einer ersten Zelle 1 und einer zweiten Zelle 2 (und an den weiteren Zellen, z. B. der dritten Zelle 3 bis Zelle n). Gemäß Schritt c) erfolgt eine Analyse einer Phasenlage 8, 9 der gemessenen Wechselspannung 6, 7 jeder Zelle 1, 2, 3. Ein Unterschied zumindest zwischen einer ersten Phasenlage 8 einer an der ersten Zelle 1 gemessenen ersten Wechselspannung 6 und einer zweiten Phasenlage 9 einer an der zweiten Zelle 2 gemessenen zweiten Wechselspannung 7 ermöglicht einen Rückschluss auf einen Unterschied der Zustände zumindest der ersten Zelle 1 und der zweiten Zelle 2.

Gemäß Schritt a) wird ein Wechselstrom 5, z. B. mit einer Frequenz 10 in die Zellen 1, 2, 3 der Batterie 4 eingeprägt. Dafür weist die Schaltung einen Schalter 35 und einen Verbraucher 34, der durch den aufgeprägten Wechselstrom 5 betrieben wird.

Die an den Zellen 1, 2, 3 gemessenen Wechselspannungen 6, 7 werden jeweils durch einen Bandpass 11 gefiltert und das so jeweils erzeugte Signal 12, 13, 14 durch einen Verstärker 15 mit Komparator verändert. Das erste Signal 12 ist die bandpassgefilterte erste Wechselspannung 6, die eine erste Phasenlage 8 aufweist und an der ersten Zelle 1 gemessen wurde. Das zweite Signal 13 ist die bandpassgefilterte zweite Wechselspannung 7, die eine zweite Phasenlage 9 aufweist und an der zweiten Zelle 2 gemessen wurde. Das dritte Signal 14 ist die entsprechend gefilterte Wechselspannung der dritten Zelle 3. Die jeweils durch den Verstärker 15 mit Komparator veränderten Signale 16, 17, 18 werden in einem Phasendetektor 19 zusammengeführt. Das erste veränderte Signal 16 basiert auf dem ersten Signal 13, das zweite veränderte Signal 17 auf dem zweiten Signal 13 und das dritte veränderte Signal 18 auf dem dritten Signal 14. Eine Phasenverschiebung 20 der gemessenen Wechselspannungen 6, 7 ist durch ein erstes Ausgangssignal 21 darstellbar.

Mit dem Bandpass 11 kann die dem aufgeprägtem Wechselstrom 5 zuzuordnende und an der Zelle 1, 2, 3 dadurch hervorgerufene Wechselspannung 6, 7 erfasst werden. Der Bandpass 11 ermöglicht also die Erfassung einer Wechselspannung 6, 7, die die Frequenz 10 des Wechselstroms 5 aufweist.

Der Verstärker 15 mit Komparator liefert ein verändertes Signal 16, 17, 18, dass die gemessene und durch den Bandpass 11 gefilterte Wechselspannung 6, 7 durch ein Rechtecksignal darstellt. Liegt eine Phasenverschiebung 20 gegenüber anderen Wechselspannungen 7, 6 vor, wird dies durch eine Verschiebung der Rechtecksignale entlang der Zeitachse deutlich (siehe Darstellung der ersten Ausgangssignale 21 in den Diagrammen).

Die durch den Verstärker 15 mit Komparator veränderten Signale 16, 17, 18 werden als zweites Ausgangssignal 22 dargestellt, so dass darstellbar ist, welche Wechselspannung 6, 7 bzw. Wechselspannungen 6, 7 eine Phasenverschiebung 20 gegenüber anderen Wechselspannungen 7, 6 aufweisen.

Sobald sich die Imaginärteile 31 der Zellwiderstände unterscheiden und damit eine Phasenverschiebung 20 der an einer Zelle 1, 2, 3 gemessenen Wechselspannung 6, 7 erzeugen, wird durch das erste Ausgangssignal 21 ein Rechtecksignal erzeugt. Dieses lässt einen Rückschluss auf einen Unterschied der Zellen 1, 2, 3 zu, z. B. auf einen Temperaturanstieg bei Beginn einer thermischen Propagation. Die zeitliche Länge des Rechtecksignals ist insbesondere proportional bzw. gleich der Stärke des Unterschieds, also z. B. der Temperaturdifferenz (siehe Darstellung der ersten Ausgangssignale 21 in den Diagrammen, das obere Diagramm zeigt keine erkennbaren ersten Ausgangssignale 21, das untere Diagramm zeigt rechteckförmige erste Ausgangssignale 21, die das Vorliegen einer Phasenverschiebung 20 anzeigen).

Die Ausgangssignale 21, 22 werden durch eine Auswerteeinheit 36 ausgewertet.

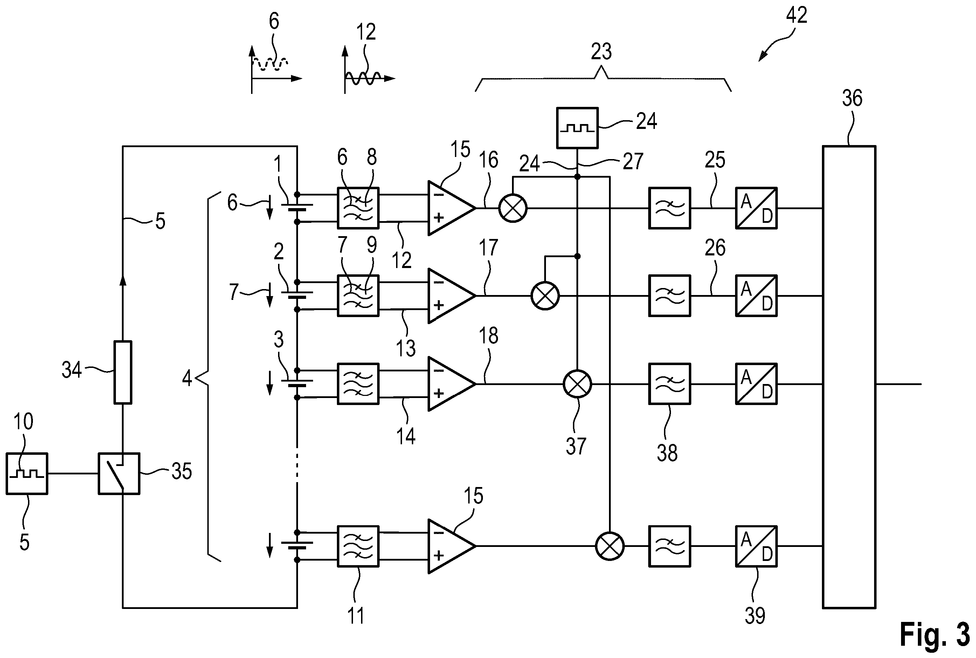

Fig. 3 zeigt eine zweite Schaltung 42. Auf die Ausführungen zu Fig. 2 wird verwiesen. Im Unterschied zur ersten Schaltung 41 werden die jeweils veränderten Signale 16, 17, 18 einem Lock-in-Verstärker 23, der mit einem Referenzspannungssignal 24 beaufschlagt wird, zugeführt, wobei der Lock-in-Verstärker 23 für jede gemessene Wechselspannung 6, 7 eine Gleichspannung 25, 26 ausgibt, deren jeweilige Höhe proportional zumindest zu einer Phasenverschiebung 20 zwischen der gemessenen Wechselspannung 6, 7 und dem Referenzspannungssignal 24 ist.

Der Verstärker 15 liefert ein verändertes Signal 16, 17, 18, dass die gemessene und durch den Bandpass 11 gefilterte Wechselspannung 6, 7 durch ein Rechtecksignal darstellt.

Das Referenzspannungssignal 23 ist ebenfalls ein Rechtecksignal. Das Referenzspannungssignal 23 weist dieselbe Frequenz 10 wie der aufgeprägte Wechselstrom 5 auf.

Ein Lock-in-Verstärker 23 ist ein Verstärker zur Messung eines schwachen elektrischen Wechselsignals, hier des veränderten Signals 16, 17, 18, das mit einem in Frequenz 10 und Phasenlage bekannten Referenzspannungssignal 24 moduliert ist. Das Gerät stellt einen schmalbandigen Bandpassfilter dar und verbessert dadurch das Signal-Rausch-Verhältnis (SNR, Signal to Noise Ratio).

Die beiden Eingangssignale des jeweiligen Lock-in-Verstärkers 23, also einerseits die gemessene Wechselspannung 6, 7, die im Bandpass 11 gefiltert und durch einen Verstärker 15 zu einem veränderten Signal 16, 17, 18 umgewandelt wurden, und andererseits das Referenzspannungssignal 24, werden in einem Mischer 37 bzw. Multiplikator miteinander multipliziert und anschließend in einem Tiefpass 38 integriert. Der Tiefpass 38 ermöglicht die Ausblendung von Signalen höherer Frequenzen 10, die beim Multiplizieren der Eingangssignale erzeugt werden.

Der jeweilige Lock-in-Verstärker 23 berechnet die Kreuzkorrelation zwischen dem veränderten Signal 16, 17, 18 und dem Referenzspannungssignal 24 für eine feste Phasenverschiebung 20 zwischen dem veränderten Signal 16, 17, 18 einer Zelle 1, 2, 3 und dem Referenzspannungssignal 24. Der Lock-in-Verstärker 23 liefert für jede Zelle 1, 2, 3 ein Gleichspannungssignal 25, 26, hier für die erste Zelle 1 ein erstes Gleichspannungssignal 25 und für die zweite Zelle 2 ein zweites Gleichspannungssignal 26, dessen Wert eine Aussage zur Phasenlage 8, 9 der gemessenen Wechselspannung 6, 7 gegenüber dem Referenzspannungssignal 24 liefert.

Ein von anderen Gleichspannungssignalen 26, 25 anderer Zellen 3, 2, 1 abweichendes Gleichspannungssignal 25, 26 einer Zelle 1, 2, 3 bedeutet, dass hier eine Phasenverschiebung 20 vorliegt und die Zelle 1, 2, 3 ggf. schadhaft ist.

Voneinander nicht abweichende Gleichspannungssignale 25, 26 deuten darauf hin, dass keine Phasenverschiebungen 20 vorliegen und dass keine der Zellen 1, 2, 3 defekt ist.

Die Gleichspannungssignale 25, 26 werden jeweils einem Analog-Digital-Wandler 39 zugeführt und dort in ein digitales Ausgangssignal umgewandelt. Dieses digitale Ausgangssignal wird einer Auswerteeinheit 36 zugeführt und darin ausgewertet.

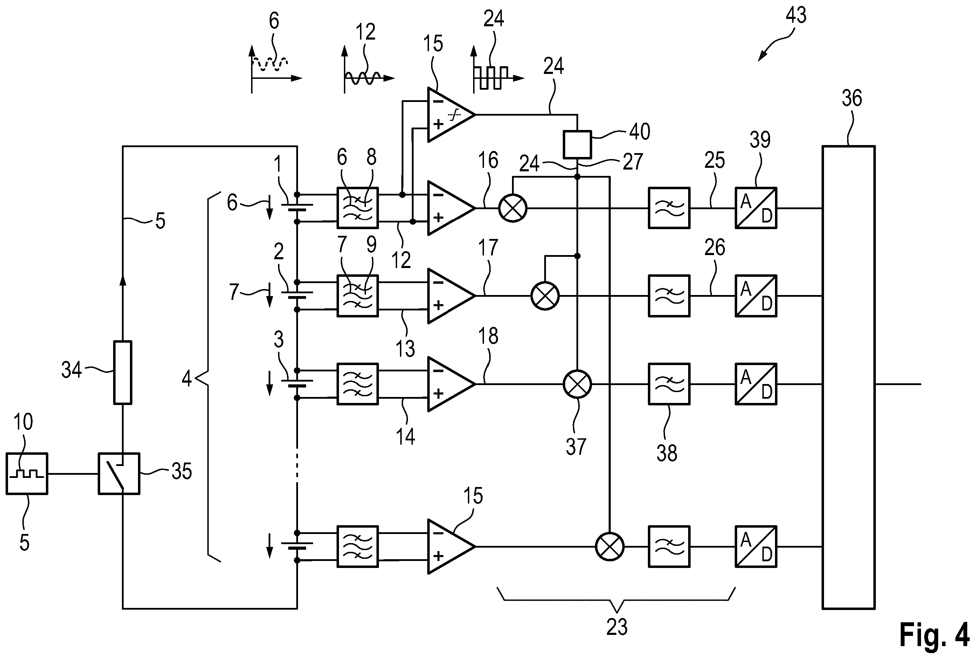

Fig. 4 zeigt eine dritte Schaltung 43. Auf die Ausführungen zu Fig. 2 und 3 wird verwiesen. Im Unterschied zur zweiten Schaltung 42 entspricht das Referenzspannungssignal 24 in Frequenz 10 und Phasenlage 8, 9 dem durch den Bandpass 11 gefilterten Signal der ersten Zelle 1 der Batterie 4. Damit kann das Referenzspannungssignal 24 eine gemeinsame erste Phasenlage 8 mit der gemessenen ersten Wechselspannung 6 der ersten Zelle 1 aufweisen.

Das Referenzspannungssignal 24 wird aus dem Bandpass-gefilterten ersten Signal 12 der gemessenen ersten Wechselspannung 6 der ersten Zelle 1 generiert. Dieses erste Signal 12 wird durch einen Verstärker 15 zu einem veränderten Signal umgewandelt und als Referenzspannungssignal 24 verwendet. Das für das Referenzspannungssignal 24 verwendete und durch den Bandpass 11 gefilterte erste Signal 12 der ersten Zelle 1 wird hinsichtlich seiner Phasenlage 20 verschoben, so dass es als phasenverschobenes Signal 27 der ersten Zelle 1 das Referenzspannungssignal 24 des Lock-in-Verstärkers 23 bildet.

Dafür ist ein Phasenschieber 40 vorgesehen, mit dem das Referenzspannungssignal 24 hinsichtlich der Phasenlage 8, 9 verschoben werden kann. Mit dem Phasenschieber 40 lässt sich die Phasenlage 8, 9 des Referenzspannungssignals 24 verändern und so nur der Imaginärteil 31 der Spannung (und damit des Widerstandes) verstärken.

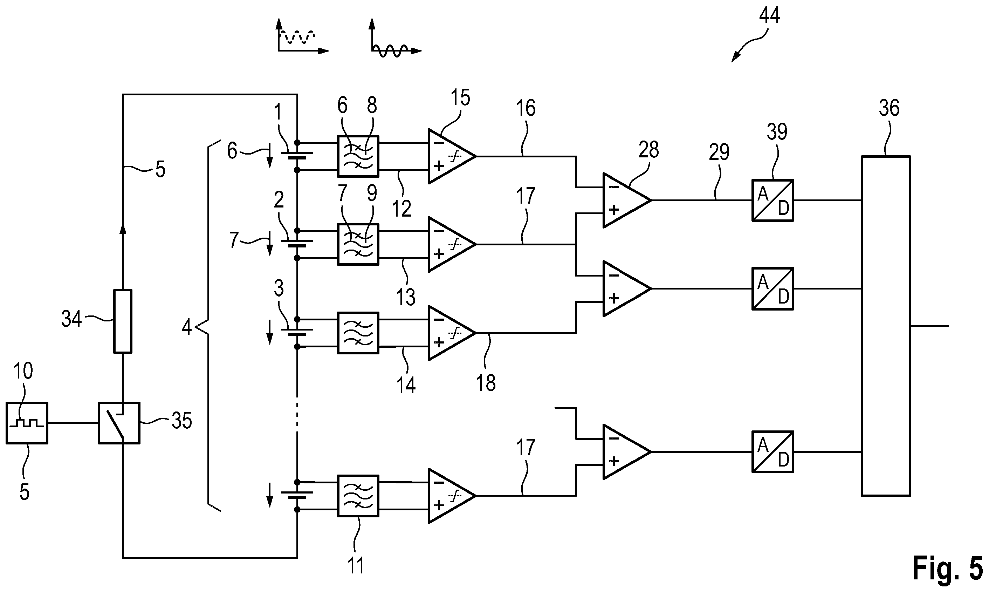

Fig. 5 zeigt eine vierte Schaltung 44. Auf die Ausführungen zu Fig. 2 bis 4 wird verwiesen. Im Unterschied zur zweiten Schaltung 42 werden die jeweils veränderten Signale 16, 17, 18 zweier Zellen, hier also der ersten Zelle 1 und der zweiten Zelle 2 sowie der zweiten Zelle 2 und der dritten Zelle 3 jeweils einem Differenzverstärker 28 zugeführt. Jede Zelle 1, 2, 3 ist mit jeder anderen über die Reihenschaltung verbundenen Zelle 3, 2, 1 über jeweils einen Differenzverstärker 28 verbunden. Der jeweilige Differenzverstärker 28 erzeugt nur dann ein Messsignal 29, wenn eine Phasenverschiebung 20 zwischen den veränderten Signalen 16, 17, 18 der jeweils über den Differenzverstärker 28 verbundenen zwei Zellen 1, 2, 3 vorliegt.

Dieses Messsignal 29 wird einem Analog-Digital-Wandler 39 zugeführt und dort in ein digitales Ausgangssignal umgewandelt. Diese digitalen Ausgangssignale werden einer Auswerteeinheit 36 zugeführt und darin ausgewertet.

### Bezugszeichenliste

- 1: erste Zelle
- 2: zweite Zelle
- 3: dritte Zelle
- 4: Batterie
- 5: Wechselstrom
- 6: erste Wechselspannung
- 7: zweite Wechselspannung
- 8: erste Phasenlage
- 9: zweite Phasenlage
- 10: Frequenz
- 11: Bandpass
- 12: erstes Signal
- 13: zweites Signal
- 14: drittes Signal
- 15: Verstärker
- 16: erstes verändertes Signal
- 17: zweites verändertes Signal
- 18: drittes verändertes Signal
- 19: Phasendetektor
- 20: Phasenverschiebung
- 21: erstes Ausgangssignal
- 22: zweites Ausgangssignal
- 23: Lock-in-Verstärker
- 24: Referenzspannungssignal
- 25: erste Gleichspannung
- 26: zweite Gleichspannung
- 27: phasenverschobenes Signal
- 28: Differenzverstärker
- 29: Messsignal
- 30: Datenverarbeitungssystem
- 31: Imaginärteil
- 32: Realteil
- 33: Zeit
- 34: Verbraucher
- 35: Schalter
- 36: Auswerteeinheit
- 37: Mischer
- 38: Tiefpass
- 39: Wandler
- 40: Phasenschieber
- 41: erste Schaltung
- 42: zweite Schaltung
- 43: dritte Schaltung
- 44: vierte Schaltung

## Patentansprüche

1. Verfahren zur Bestimmung eines Zustands mindestens einer Zelle (1, 2, 3) einer Batterie (4), wobei die Batterie (4) eine Mehrzahl von Zellen (1, 2, 3) aufweist, die miteinander in Reihe geschaltet sind; wobei das Verfahren zumindest die folgenden Schritte umfasst:
a) Beaufschlagen der Mehrzahl von Zellen (1, 2, 3) mit einem Wechselstrom (5);
b) Messen der dadurch erzeugten Wechselspannung (6, 7) an zumindest einer ersten Zelle (1) und einer zweiten Zelle (2);
c) Analyse einer Phasenlage (8, 9) der gemessenen Wechselspannung (6, 7) jeder Zelle (1, 2); wobei
ein Unterschied zumindest zwischen einer ersten Phasenlage (7) einer an der ersten Zelle (1) gemessenen ersten Wechselspannung (6) und einer zweiten Phasenlage (9) einer an der zweiten Zelle (2) gemessenen zweiten Wechselspannung (7) einen Rückschluss auf einen Unterschied der Zustände zumindest der ersten Zelle (1) und der zweiten Zelle (2) erzeugt; **dadurch gekennzeichnet, dass** nur die Phasenlage (8, 9) der an den Zellen (1, 2, 3) gemessenen Wechselspannungen (6, 7) zueinander und nicht die Phasenbeziehung zwischen einem Strom und einer Spannung ausgewertet wird.

2. Verfahren nach Patentanspruch 1, wobei ausschließlich die Wechselspannungen (6, 7) gemessen werden.

3. Verfahren nach einem der vorhergehenden Patentansprüche, wobei der Wechselstrom (5) eine konstante Frequenz (10) aufweist.

4. Verfahren nach einem der vorhergehenden Patentansprüche 1 bis 3, wobei der Wechselstrom (5) eine sich ändernde Frequenz (10) aufweist.

5. Verfahren nach einem der vorhergehenden Patentansprüche, wobei der Wechselstrom (5) eine Frequenz (10) mit nur einer Periodenlänge aufweist

6. Verfahren nach einem der vorhergehenden Patentansprüche, wobei die an den Zellen (1, 2, 3) gemessenen Wechselspannungen (6, 7) jeweils durch einen Bandpass (11) gefiltert und das so jeweils erzeugte Signal (12, 13, 14) durch einen Verstärker (15) mit Komparator verändert wird, wobei die jeweils veränderten Signale (16, 17, 18) in einem Phasendetektor (19) zusammengeführt und eine Phasenverschiebung (20) der gemessenen Wechselspannungen (6, 7) durch ein erstes Ausgangssignal (21) darstellbar ist.

7. Verfahren nach Patentanspruch 6, wobei die veränderten Signale (16, 17, 18) als zweites Ausgangssignal (22) dargestellt werden, so dass darstellbar ist, welche Wechselspannungen (6, 7) eine Phasenverschiebung (20) gegenüber anderen Wechselspannungen (7, 6) aufweisen.

8. Verfahren nach einem der vorhergehenden Patentansprüche 1 bis 5, wobei die an den Zellen (1, 2, 3) gemessenen Wechselspannungen (6, 7) jeweils durch einen Bandpass (11) gefiltert und das so jeweils erzeugte Signal (12, 13, 14) durch einen Verstärker (15) verändert wird, wobei die jeweils veränderten Signale (16, 17, 18) einem Lock-in-Verstärker (23), der mit einem Referenzspannungssignal (24) beaufschlagt wird, zugeführt werden, wobei der Lock-in-Verstärker (23) für jede gemessene Wechselspannung (6, 7) eine Gleichspannung (25, 26) ausgibt, deren jeweilige Höhe proportional zumindest zu einer Phasenverschiebung (20) zwischen der gemessenen Wechselspannung (6, 7) und dem Referenzspannungssignal (24) ist.

9. Verfahren nach Patentanspruch 8, wobei das Referenzspannungssignal (24) in Frequenz (10) und Phasenlage (8) dem durch den Bandpass (11) gefilterten Signal (12, 13, 14) einer Zelle (1, 2, 3) entspricht.

10. Verfahren nach Patentanspruch 8, wobei das für das Referenzspannungssignal (24) verwendete und durch den Bandpass (11) gefilterte Signal (12, 13, 14) einer Zelle (1, 2, 3) hinsichtlich seiner Phasenlage (8) verschoben wird, so dass es als phasenverschobenes Signal (27) einer Zelle (1, 2, 3) das Referenzspannungssignal (24) des Lock-in-Verstärkers (23) bildet.

11. Verfahren nach einem der vorhergehenden Patentansprüche 1 bis 5, wobei die an den Zellen (1, 2, 3) gemessenen Wechselspannungen (6, 7) jeweils durch einen Bandpass (11) gefiltert und das so jeweils erzeugte Signal (12, 13, 14) durch einen Verstärker (15) verändert wird, wobei die jeweils veränderten Signale (16, 17, 18) zweier Zellen (1, 2, 3) einem Differenzverstärker (28) zugeführt werden; wobei jede Zelle (1, 2, 3) mit jeder anderen in einer Reihenschaltung verbundenen Zelle (3, 2, 1) über jeweils einen Differenzverstärker (28) verbunden ist; wobei der Differenzverstärker (28) ein Messsignal (29) nur dann erzeugt, wenn eine Phasenverschiebung (20) zwischen den veränderten Signalen (16, 17, 18) der zwei Zellen (1, 2, 3) vorliegt.

12. Datenverarbeitungssystem (30), das zur Durchführung eines Verfahrens nach einem der vorhergehenden Patentansprüche ausgestattet, konfiguriert oder programmiert ist, wobei das Datenverarbeitungssystem (30) Phasenlagen (8, 9) von, an einer Mehrzahl von Zellen (1, 2, 3) einer Batterie (4) gemessenen, Wechselspannungen (6, 7) verarbeitet und miteinander vergleicht; also nur die Phasenlage (8, 9) der an den Zellen (1, 2, 3) gemessenen Wechselspannungen (6, 7) zueinander auswertet und nicht die Phasenbeziehung zwischen einem Strom und einer Spannung.

## Claims

1. Method for determining a state of at least one cell (1, 2, 3) of a battery (4), the battery (4) comprising a plurality of cells (1, 2, 3) connected in series; the method comprising at least the following steps:
a) applying an alternating current (5) to the plurality of cells (1, 2, 3);
b) measuring the alternating voltage (6, 7) thus generated at at least a first cell (1) and a second cell (2);
c) analyzing a phase position (8, 9) of the measured alternating voltage (6, 7) of each cell (1, 2); with a difference at least between a first phase position (7) of a first alternating voltage (6) measured at the first cell (1) and a second phase position (9) of a second alternating voltage (7) measured at the second cell (2) generating a conclusion about a difference in the states of at least the first cell (1) and the second cell (2); **characterized in that**
only the phase position (8, 9) of the alternating voltages (6, 7) measured at the cells (1, 2, 3) relative to one another is evaluated and not the phase relationship between a current and a voltage.

2. Method according to claim 1, wherein only the alternating voltages (6, 7) are measured.

3. Method according to either of the preceding claims, wherein the alternating current (5) has a constant frequency (10).

4. Method according to any of the preceding claims 1 to 3, wherein the alternating current (5) has a changing frequency (10).

5. Method according to any of the preceding claims, wherein the alternating current (5) has a frequency (10) with only one period length.

6. Method according to any of the preceding claims, wherein the alternating voltages (6, 7) measured at the cells (1, 2, 3) are each filtered by a bandpass (11) and the signal (12, 13, 14) thus generated is modified by an amplifier (15) having a comparator, wherein the modified signals (16, 17, 18) are combined in a phase detector (19) and a phase shift (20) of the measured alternating voltages (6, 7) can be represented by a first output signal (21).

7. Method according to claim 6, wherein the modified signals (16, 17, 18) are represented as a second output signal (22) so that it is possible to represent which alternating voltages (6, 7) have a phase shift (20) compared to other alternating voltages (7, 6).

8. Method according to any of the preceding claims 1 to 5, wherein the alternating voltages (6, 7) measured at the cells (1, 2, 3) are each filtered by a bandpass (11) and the signal (12, 13, 14) thus generated is modified by an amplifier (15), wherein the modified signals (16, 17, 18) are fed to a lock-in amplifier (23) which is supplied with a reference voltage signal (24), wherein the lock-in amplifier (23) outputs a direct voltage (25, 26) for each measured alternating voltage (6, 7), the particular magnitude of which direct voltage is proportional at least to a phase shift (20) between the measured alternating voltage (6, 7) and the reference voltage signal (24).

9. Method according to claim 8, wherein the reference voltage signal (24) corresponds in frequency (10) and phase position (8) to the signal (12, 13, 14) of a cell (1, 2, 3) filtered by the bandpass (11).

10. Method according to claim 8, wherein the signal (12, 13, 14) of a cell (1, 2, 3) used for the reference voltage signal (24) and filtered by the bandpass (11) is shifted with respect to its phase position (8) so that it forms the reference voltage signal (24) of the lock-in amplifier (23) as a phase-shifted signal (27) of a cell (1, 2, 3).

11. Method according to any of the preceding claims 1 to 5, wherein the alternating voltages (6, 7) measured at the cells (1, 2, 3) are each filtered by a bandpass (11) and the signal (12, 13, 14) thus generated is modified by an amplifier (15), wherein the modified signals (16, 17, 18) of two cells (1, 2, 3) are fed to a differential amplifier (28); wherein, via a differential amplifier (28) in each case, each cell (1, 2, 3) is connected to every other cell (3, 2, 1) connected in a series circuit; wherein the differential amplifier (28) generates a measurement signal (29) only if there is a phase shift (20) between the modified signals (16, 17, 18) of the two cells (1, 2, 3).

12. Data processing system (30) which is equipped, configured or programmed to carry out a method according to any of the preceding claims, wherein the data processing system (30) processes and compares phase positions (8, 9) of alternating voltages (6, 7) measured at a plurality of cells (1, 2, 3) of a battery (4); i.e., only evaluates the phase position (8, 9) of the alternating voltages (6, 7) measured at the cells (1, 2, 3) relative to one another and not the phase relationship between a current and a voltage.

## Revendications

1. Procédé permettant de déterminer un état d'au moins une cellule (1, 2, 3) d'une batterie (4), dans lequel la batterie (4) présente une pluralité de cellules (1, 2, 3) qui sont montées en série les unes avec les autres ; dans lequel le procédé comprend au moins les étapes suivantes :
a) application d'un courant alternatif (5) à la pluralité de cellules (1, 2, 3) ;
b) mesure de la tension alternative (6, 7) ainsi générée sur au moins une première cellule (1) et une deuxième cellule (2) ;
c) analyse d'une position de phase (8, 9) de la tension alternative (6, 7) mesurée de chaque cellule (1, 2) ; dans lequel une différence entre au moins une première position de phase (7) d'une première tension alternative (6) mesurée sur la première cellule (1) et une seconde position de phase (9) d'une seconde tension alternative (7) mesurée sur la deuxième cellule (2) génère une conclusion quant à une différence entre les états au moins de la première cellule (1) et de la deuxième cellule (2) ; **caractérisé en ce que**
seule la position de phase (8, 9) entre les tensions alternatives (6, 7) mesurées sur les cellules (1, 2, 3) est évaluée et non la relation de phase entre un courant et une tension.

2. Procédé selon la revendication 1, dans lequel on mesure exclusivement les tensions alternatives (6, 7).

3. Procédé selon l'une des revendications précédentes, dans lequel le courant alternatif (5) présente une fréquence (10) constante.

4. Procédé selon l'une des revendications précédentes 1 à 3, dans lequel le courant alternatif (5) présente une fréquence (10) qui varie.

5. Procédé selon l'une des revendications précédentes, dans lequel le courant alternatif (5) présente une fréquence (10) avec une seule longueur de période

6. Procédé selon l'une des revendications précédentes, dans lequel les tensions alternatives (6, 7) mesurées sur les cellules (1, 2, 3) sont respectivement filtrées par un filtre passe-bande (11) et le signal (12, 13, 14) ainsi respectivement généré est modifié par un amplificateur (15) avec comparateur, dans lequel les signaux (16, 17, 18) respectivement modifiés sont réunis dans un détecteur de phase (19) et un déphasage (20) des tensions alternatives (6, 7) mesurées peut être représenté par un premier signal de sortie (21).

7. Procédé selon la revendication 6, dans lequel les signaux (16, 17, 18) modifiés sont représentés comme second signal de sortie (22), de sorte qu'il est possible de représenter quelles tensions alternatives (6, 7) présentent un déphasage (20) par rapport à d'autres tensions alternatives (7, 6).

8. Procédé selon l'une des revendications précédentes 1 à 5, dans lequel les tensions alternatives (6, 7) mesurées sur les cellules (1, 2, 3) sont respectivement filtrées par un filtre passe-bande (11) et le signal (12, 13, 14) ainsi respectivement généré est modifié par un amplificateur (15), dans lequel les signaux (16, 17, 18) respectivement modifiés sont transmis à un amplificateur à verrouillage (23), auquel est appliqué un signal de tension de référence (24), dans lequel l'amplificateur à verrouillage (23) délivre, pour chaque tension alternative (6, 7) mesurée, une tension continue (25, 26) dont la valeur respective est proportionnelle au moins à un déphasage (20) entre la tension alternative (6, 7) mesurée et le signal de tension de référence (24).

9. Procédé selon la revendication 8, dans lequel le signal de tension de référence (24) correspond en fréquence (10) et en position de phase (8) au signal (12, 13, 14) d'une cellule (1, 2, 3) filtré par le filtre passe-bande (11).

10. Procédé selon la revendication 8, dans lequel le signal (12, 13, 14) d'une cellule (1, 2, 3) utilisé pour le signal de tension de référence (24) et filtré par le filtre passe-bande (11) est déphasé par rapport à sa position de phase (8), de sorte qu'il forme, en tant que signal déphasé (27) d'une cellule (1, 2, 3), le signal de tension de référence (24) de l'amplificateur à verrouillage (23).

11. Procédé selon l'une des revendications précédentes 1 à 5, dans lequel les tensions alternatives (6, 7) mesurées sur les cellules (1, 2, 3) sont filtrées respectivement par un filtre passe-bande (11) et le signal (12, 13, 14) ainsi respectivement généré est modifié par un amplificateur (15), dans lequel les signaux (16, 17, 18) respectivement modifiés de deux cellules (1, 2, 3) sont transmis à un amplificateur différentiel (28) ; dans lequel chaque cellule (1, 2, 3) est reliée à chaque autre cellule (3, 2, 1) reliée dans un montage en série par l'intermédiaire respectivement d'un amplificateur différentiel (28) ; dans lequel l'amplificateur différentiel (28) ne génère un signal de mesure (29) que lorsqu'il existe un déphasage (20) entre les signaux (16, 17, 18) modifiés des deux cellules (1, 2, 3).

12. Système de traitement de données (30) qui est équipé, configuré ou programmé pour la mise en œuvre d'un procédé selon l'une des revendications précédentes, dans lequel le système de traitement de données (30) traite et compare entre elles des positions de phase (8, 9) de tensions alternatives (6, 7) mesurées sur une pluralité de cellules (1, 2, 3) d'une batterie (4) ; c'est-à-dire qu'il évalue uniquement la position de phase (8, 9) des tensions alternatives (6, 7) mesurées sur les cellules (1, 2, 3) les unes par rapport aux autres et non la relation de phase entre un courant et une tension.
